Europäisches Patentamt

European Patent Office

Office européen des brevets

(19)

(11) Veröffentlichungsnummer : **0 568 532 B1**

## (12) EUROPÄISCHE PATENTSCHRIFT

(45) Veröffentlichungstag der Patentschrift :
**18.01.95 Patentblatt 95/03**

(51) Int. Cl.⁶ : **H04B 1/66,** H03M 7/30

(21) Anmeldenummer : **91911829.9**

(22) Anmeldetag : **27.06.91**

(86) Internationale Anmeldenummer :
**PCT/EP91/01211**

(87) Internationale Veröffentlichungsnummer :
**WO 92/13396 06.08.92 Gazette 92/21**

(54) **VERFAHREN ZUM ÜBERTRAGEN DIGITALISIERTER, BLOCKCODIERTER TONSIGNALE UNTER VERWENDUNG VON SKALENFAKTOREN.**

(30) Priorität : **26.01.91 DE 4102324**

(43) Veröffentlichungstag der Anmeldung :
**10.11.93 Patentblatt 93/45**

(45) Bekanntmachung des Hinweises auf die
Patenterteilung :
**18.01.95 Patentblatt 95/03**

(84) Benannte Vertragsstaaten :
**AT CH DE DK ES FR GB IT LI NL SE**

(56) Entgegenhaltungen :
**EP-A- 64 119**

(73) Patentinhaber : **Institut für Rundfunktechnik GmbH
Floriansmühlstrasse 60
D-80939 München (DE)**

(72) Erfinder : **WIESE, Detlef
Eschenweg 19 b
W-8055 Goldach (DE)**

(74) Vertreter : **Konle, Tilmar, Dipl.-Ing.
Benderstrasse 23 a
D-81247 München (DE)**

EP 0 568 532 B1

**Beschreibung**

Die Erfindung bezieht sich auf ein Verfahren gemäß dem Oberbegriff des Patentanspruchs 1. Ein derartiges Verfahren ist aus der EP-A-64119 bekannt.

Zum Übertragen von digitalisierten Tonsignalen ist es bekannt (DE-PS 33 28 344), bei der Blockcodierung aus dem Betrag des Spitzenwertes einer Sequenz (Block) von Signalwerten einen Skalenfaktor zu bilden, welcher angibt, in welchem von mehreren Größenbereichen die Amplitude des Spitzenwertes liegt. Zusätzlich können, wie aus der DE-PS 36 39 753 bekannt ist, die abgetasteten Signalwerte in einer Vielzahl spektraler Teilbandsignale dargestellt werden und die Abtastwerte der einzelnen Teilbänder nach Maßgabe der jeweiligen Mithörschwelle des menschlichen Gehörs im Sinne einer Irrelevanz- und Redundanzverminderung geändert werden. Anstelle einer Aufteilung in spektrale Teilbänder ist es auch möglich, das digitalisierte Tonsignal einer Fourier-Analyse zu unterziehen und für Gruppen von Spektralwerten die Skalenfaktoren zu bestimmen sowie eine Irrelevanz- und Redundanzverminderung durchzuführen. Dabei wird für qualitativ hochwertige Tonsignale, z.B. Hörrundfunksignale, eine solche Irrelevanz- und Redundanzverringerung angestrebt, daß das komprimierte digitale Tonsignal in die Hierarchie des ISDN-Leistungsnetzes paßt, d.h. eine konstante Bitrate von n64 k/Bit/s aufweist. Um insbesondere auch bei geringen Bitraten von 64 kBit/s eine zufriedenstellende Tonqualität zu erzielen, müssen nicht nur die Nutzinformationen, sondern auch die Steuerinformationen, wie z.B. die Skalenfaktoren, hinsichtlich ihrer Datenrate extrem komprimiert werden. Aus der EP-A-64 119 ist es bei der Blockcodierung von schmalbandigen Sprachsignalen bekannt, zur Reduktion der Anzahl der pro Block bzw. Teilband zu übertragenden Skalenfaktoren zunächst die Differenz von aufeinanderfolgenden Skalenfaktoren eines Blockes bzw. Teilbandes zu bilden. Bei Unter- bzw. Überschreitung eines vorbestimmten Differenz-Wertebereiches werden alle betrachteten Skalenfaktoren übertragen, im anderen Falle nur der größte der betrachteten Skalenfaktoren. Um decoderseitig erkennen zu können, für wie viele Skalenfaktoren ein übertragener Skalenfaktor Gültigkeit hat, wird zusätzlich zu den Skalenfaktoren eine Kenninformation mitübertragen.

Bei der bekannten Kompression der Skalenfaktoren wird indessen nur redundante Information reduziert, nicht dagegen irrelevante Information aufgrund psyochoakustischer Gesichtspunkte, welche die Vor- und Nachverdeckungseffekte des menschlichen Gehöres berücksichtigen.

Die Aufgabe der Erfindung besteht demgegenüber darin, für die Skalenfaktoren eine Informationsreduktion vorzunehmen, bei der neben redundanter Information auch irrelevante Information reduziert wird.

Diese Aufgabe wird erfindungsgemäß durch die kennzeichnenden Merkmale des Patentanspruchs 1 gelöst.

Die Erfindung wird nachstehend anhand eines Ausführungsbeispiels näher erläutert.

Die bitsparende Skalenfaktorübertragung basiert auf der Erkennung und Codierung von Mustern, wobei sowohl Redundanz als auch Irrelevanz eliminiert werden.

Die Eingangsmatrix besteht aus k Spalten und n Zeilen, wobei k die Anzahl zeitlich aufeinanderfolgender Skalenfaktoren und n die Anzahl von Teilbändern repräsentiert. Die Beschreibung erfolgt ab hier allgemein innerhalb der linken Spalte und unter Verwendung eines Beispiels innerhalb der rechten Spalte. Bei dem Beispiel (rechts) handelt es sich um drei aufeinanderfolgende Skalenfaktoren von insgesamt 32 Teilbändern (im folg. als Rahmen bez.) . Die Skalenfaktoren sind mit 6 bit quantisiert und können somit $2^6=64$ mögliche Werte annehmen. Ein Block für den ein Skalenfaktor gebildet wird hat die Länge von 8 ms.

Eingangsmatrix :

$$\begin{bmatrix} scf_{11} & scf_{12} & \cdots\cdots & scf_{1k} \\ scf_{21} & & & \\ \vdots & & & \\ \phantom{.} & & & \\ scf_{n1} & \cdots\cdots & & scf_{nk} \end{bmatrix} \qquad\Big|\qquad \begin{bmatrix} scf_{11} & scf_{12} & scf_{13} \\ scf_{21} & & \\ \vdots & & \\ \phantom{.} & & \\ scf_{32\,1} & \cdots\cdots & scf_{32\,3} \end{bmatrix} \qquad \begin{matrix} 3*6\,bit = 18\,bit \\ 3*6\,bit = 18\,bit \\ \vdots \\ \phantom{.} \\ 3*6\,bit = 18\,bit \end{matrix}$$

$$\text{ges. Rahmen } 32 * 18\,bit \qquad = 576\,bit$$

Es folgt die Berechnung der Differenzen d aufeinanderfolgender Werte jeder Zeile und/oder Spalte. Sie werden in einer Zwischenmatrix festgehalten. Die Größe der Differenzen ist abhängig von der absoluten Blocklänge (Zeile), bzw. von der Breite der Teilbänder (Spalte). Im folgenden werden nur zeitlich aufeinanderfolgende Skalenfaktoren betrachtet. z.B. :

$$d_{1,21} = scf_{12} - scf_{11} \qquad | \qquad dto.$$

Die Zwischenmatrix hat k-1 Spalten (bei Betrachtung der Spalten auch n-1 Zeilen).

Zwischenmatrix :

$$\begin{bmatrix} d_{1,21} & d_{1,32} & \cdots & d_{1,kk,} \\ d_{2,21} & & & \\ \vdots & & & \\ d_{n,21} & \cdots\cdots\cdots\cdots & & d_{n,kk-1} \end{bmatrix} \qquad \Bigg| \qquad \begin{bmatrix} d_{1,21} & d_{1,32} \\ d_{2,21} & \\ \vdots & \\ d_{32,21} & d_{32,32} \end{bmatrix}$$

Die möglichen Differenzen $D_i$ werden unter Verwendung einer Tabelle in 1 Klassen eingeteilt. Eine Klasse 1 ist eine Menge von einer oder mehrerer Differenzen D. Für das Beispiel auf der rechten Seite werden die Differenzen D fünf Klassen 1 zugewiesen, wobei eine oder mehrere mögliche Differenzen zu einer Klasse gehören:

$$\begin{aligned} l_1 &= \{D_1, D_2, ..., D_6\} \\ l_2 &= \{D_7, D_8, ..., D_{12}\} \\ l_3 &= \{D_{13}, D_{14}, ..., D_{17}\} \\ l_4 &= \{D_{18}\} \\ &\vdots \\ l_n &= \{D_{i-4}, D_{i-3}, ..., D_i\} \end{aligned}$$

$$\begin{aligned} &\text{wenn } d < -2 \text{ und } d > -64 && l_1 \\ &\text{wenn } d > -3 \text{ und } d < 0 && l_2 \\ &\text{wenn } d = 0 && l_3 \\ &\text{wenn } d < 3 \text{ und } d > 0 && l_4 \\ &\text{wenn } d > 2 \text{ und } d < 64 && l_5 \end{aligned}$$

Alle möglichen Sequenzen von Klassen 1 ergeben $(k-1)^1$ Möglichkeiten für die Kombination c :

$$\begin{aligned} c_1 &= l_1 \, l_1 \, \cdots \, l_1 \\ c_2 &= l_1 \, l_1 \, \cdots \, l_2 \\ c_3 &= l_1 \, l_1 \, \cdots \, l_3 \\ &\vdots \\ &\vdots \\ c_{(k-1)^1} &= l_{k-1} \, l_{k-1} \, \cdots \, l_{k-1} \end{aligned}$$

Die Datenreduktion wird dadurch erreicht, daß den Kombinationen c jeweils ein Skalenfaktorübertragungsmuster zugeordnet wird. Dieses Muster besteht aus einer Steuerinformation und einer Sequenz von Skalenfaktoren, wobei die Menge an verschiedenen Skalenfaktoren innerhalb einer Sequenz kleiner oder gleich der Menge verschiedener Skalenfaktoren aus der Eingangsmatrix ist. Die Bestimmung der Übertragungsmuster, die aus den klassierten Differenzen hervorgegangen sind, erfolgt aufgrund statistischer Kenntnisse des Signals und nach psychoakustischen Gesichtspunkten, und zwar bezogen auf die Vor- und Nachverdeckungseffekte des menschlichen Gehörs. Ändern sich z.B. die Skalenfaktoren einer Zeile der Eingangsmatrix nicht, so ist es nicht notwendig alle Skalenfaktoren zu übertragen, da dies redundante Information ist (Redundanz). Ansteigende Skalenfaktoren müßen genauer übertragen werden als abfallende, da aus der Psychoakustik bekannt ist, daß das menschliche Gehör eine ausgeprägte Nachverdeckung im Bereich bis zu 200ms, jedoch nur eine Vorverdeckung im Bereich bis zu 20ms aufweist (Irrelevanz).

Bei einer Eingangsmatrix mit z. B. drei Spalten ergeben sich bei zeilenweiser Betrachtung zwei in Klassen einzuteilende Differenzen und 25 Kombinationsmöglichkeiten c. Jeder Kombination c wird ein Skalenfaktorübertragungsmuster zugeordnet. Daraus ergibt sich eine bestimmte Anzahl zu übertragender Skalenfaktoren und eine Steuerinformation, an welcher Position sich die Skalenfaktoren befinden, bzw. ändern. Bei diesem Beispiel müssen ein, zwei oder drei Skalenfaktoren und eine Steuerinformation von 2bit übertregen werden.

Klassenfolge Kombination Übertragungsmuster Anz. von SCF Steuerinf.

| Klassenfolge | Kombination | Übertragungsmuster | Anz. von SCF | Steuerinf. |
|---|---|---|---|---|
| $l_1\ l_1$ | $c_1$ | scf1 scf2 scf3 | 3 (18 bit) | 11 (2 bit) |
| $l_1\ l_2$ | $c_2$ | scf1 scf2 scf2 | 2 (12 bit) | 01 (2 bit) |
| $l_1\ l_3$ | $c_3$ | scf1 scf2 scf2 | ... | |
| $l_1\ l_4$ | $c_4$ | scf1 scf3 scf3 | ... | |
| $l_1\ l_5$ | . | . . . . . | ... | |
| $l_2\ l_1$ | $c_6$ | scf1 scf1 scf3 | 2 (6 bit) | 10 (2 bit) |
| $l_2\ l_2$ | $c_7$ | scf1 scf1 scf1 | 1 (6 bit) | 00 (2 bit) |
| $l_2\ l_3$ | | . | ... | |
| $l_2\ l_4$ | | . | | |
| $l_2\ l_5$ | | | | |
| $l_3\ l_1$ | | | | |
| : | | | | |
| $l_5\ l_5$ | $c_{25}$ | | | |

Für dieses Beispiel ergeben sich vier mögliche Übertragungsmuster, somit eine Steuerinformation von 2 bit:

1. drei verschiedene Skalenfaktoren

     s1 s2 s3    00

Datenfluß für einen Rahmen (3*6bit + 2bit)*32 = 640bit

2. erster Skalenfaktor für erste Position, zweiter für zweite und dritte Position

     s1 s3 s3    01

     s1 s2 s2

Datenfluß für einen Rahmen (2*6bit + 2bit)*32 = 448bit

3. erster Skalenfaktor für erste und zweite Position, dritter für dritte Position

     s2 s2 s3    10

     s1 s1 s3

Datenfluß für einen Rahmen (2*6bit + 2bit)*32 = 448bit

4. ein Skalenfaktor für alle drei Positionen

     s1 s1 s1    11

     s2 s2 s2

     s3 s3 s3

Datenfluß für einen Rahmen (1*6bit + 2bit)*32 = 256bit

Bei Betrachtung von nur drei zeitlich aufeinanderfolgenden Skalenfaktoren (bei dem Beispiel entspricht der Rahmen genau 24ms) ergibt sich der Vorteil eines geringen Decoder-delays und einer kleinen Accessunit (kleinste zu decodierende Einheit). Wird auf diese Vorteile kein Wert gelegt so kann bei Betrachtung größerer Zeitabschnitte eine höhere Datenreduktion erzielt werden.

- durch eine Eingangsmatrix mit einer höheren Spaltenzahl
- durch die Übertragung der Information für einen Rahmen 'kein scf übertragen'

Zahlenbeispiel :

| aufeinanderfolg. Skalenfakt.: | 10 | 40 | 38 | 37 | 36 | 38 |
|---|---|---|---|---|---|---|
| berechnete Differenzen : | | 30 | −2 | −1 | +2 | |
| zugeordnete Klasse : | | $l_5$ | $l_2$ | $l_2$ | $l_4$ | |
| Übertragungsmuster : | scf1 | scf2 | scf2 | max( scf1, scf2, scf3 ) | | |
| übertragene(r) Skalenfakt. : | 10, | 40 | | 38 | | |
| Steuerinformation : | | 01 | | 00 | | |
| decodierte Skalenfaktoren : | 10 | 40 | 40 | 38 | 38 | 38 |

**Patentansprüche**

1. Verfahren zum Übertragen digitalisierter, blockcodierter Tonsignale unter Verwendung von Skalenfaktoren, die bei der Blockcodierung der digitalisierten Tonsignale aus dem Betrag des Spitzenwertes einer Sequenz (Block) von Signalwerten gebildet und in quantisierter Form den abgetasteten Signalwerten der betreffenden Sequenz hinzugeführt werden, bei dem coderseitig

a) aus einer Anzahl von k zeitlich aufeinanderfolgenden Skalenfaktoren ($scf_{11}$, $scf_{12}$ bis $scf_{1k}$; ...$scf_{n1}$, $scf_{n2}$, ...$scf_{nk}$) jeweils eines Frequenz-Teilbandes oder einer Gruppe von Spektralwerten des in n Teilbändern oder Spektralwerten unterteilten Tonsignals (mit n 1) die Differenzen

$$d_{12-11} = scf_{12} - scf_{11}$$
$$\text{bis}$$
$$d_{1k - 1(k - 1)} = scf_{1k} - scf_{1\ (k - 1)};$$
$$.$$
$$.$$
$$.$$
$$d_{n2 - n1} = scf_{n2} - scf_{n1}$$
$$\text{bis}$$
$$d_{nk - n(k - 1)} = sfn_{nk} - scf_{n\ (k - 1)}$$

nach Vorzeichen und Betrag gebildet werden;
die gemäß Schritt a) gebildeten $(k-1) * n$ Differenzen in zumindest zwei Werteklassen eingestuft werden, von denen jede Werteklasse eine Menge von einer oder mehreren möglichen Differenzen umfaßt,
c) aufgrund der gemäß Schritt b) gebildeten Folge von $(k-1) * n$ Werteklassen - getrennt für jedes der n Teilbänder bzw. Spektralwertegruppen - Skalenfaktoren selektiert und mit einer Kenninformation versehen werden, wobei die Anzahl von aufeinanderfolgenden, unterschiedlichen selektierten Skalenfaktoren innerhalb der Folge kleiner oder gleich der Anzahl der aufeinanderfolgenden, unterschiedlichen Skalenfaktoren des betrachteten Teilbandes bzw. Spektralwertegruppe ist, und wobei die Kenninformation die Zuordnung der selektierten Skalenfaktoren zu jeweils einem oder mehreren der k Blöcke der abgetasteten Signalwerte des betreffenden Teilbandes bzw. Spektralwertegruppe identifiziert,
und bei dem decoderseitig

d) anhand der Kenninformation den Blöcken der abgetasteten Signalwerte die zugehörigen selektierten Skalenfaktoren zugeordnet werden, und
e) aus den abgetasteten Signalwerten sowie den zugeordneten selektierten Skalenfaktoren wieder Tonsignale erzeugt werden, die mehr oder weniger den ursprünglichen Tonsignalen entsprechen,
**dadurch gekennzeichnet,** daß bei der Blockcodierung innerhalb von irrelevanz- und redundanzmindernden Tondaten-Reduktionsverfahren folgende Verfahrensschritte vorgesehen werden:
f) Die gemäß Schritt a) gebildeten $(k-1)n$ Differenzen werden in mehr als zwei Werteklassen eingestuft;
g) bei der Selektion der Skalenfaktoren gemäß Schritt c) wird getrennt für jedes der n Teilbänder bzw. Spektralwertegruppen ein Übertragungsmuster neuer Skalenfaktoren nach psychoakustischen Gesichtspunkten bezogen auf die Vor- und Nachverdeckungseffekte des menschlichen Gehörs bestimmt, wobei zwischen psychoakustisch relevanten Änderungen der Skalenfaktoren unterschieden wird, und
h) als Kenninformation eine Steuerinformation verwendet wird, welche angibt, an welchen Stellen k sich die neuen Skalenfaktoren befinden.

2. Verfahren nach Anspruch 1, **dadurch gekennzeichnet,** daß die Steuerinformation ggfs. besagt, daß kein neuer Skalenfaktor übertragen wird, sondern der vorangegangene neue Skalenfaktor für alle betreffenden k Blöcke gilt.

**Claims**

1. A method of transmitting digitized, block coded audio signals using scale factors formed during block coding of the digitized audio signals from the amount of the peak value of a sequence (block) of signal values and brought in quantized form to the sampled signal values of the respective sequence, wherein, in the coder:

a) from a plurality of k timely successive scale factors ($scf_{11}$, $scf_{12}$ to $scf_{1k}$; ...$scf_{n1}$, $scf_{n2}$, ...$scf_{nk}$) of each frequency sub-band or of a group of spectral values of an audio signal subdivided into n sub-bands or spectral values (where $n \geq 1$), the differences

$$d_{12-11} = scf_{12} - scf_{11}$$
$$\text{to}$$
$$d_{1k - 1(k - 1)} = scf_{1k} - scf_{1(k - 1)};$$

.

.

.

$$d_{n2 - n1} = scf_{n2} - scf_{n1}$$
$$\text{to}$$
$$d_{nk - n(k - 1)} = sfn_{nk} - scf_{n(k - 1)}$$

are formed according to sign and amount;

(b) the $(k-1)*n$ differences formed according to step (a) are grouped in at least two value classes with each value class including a quantity of one or a plurality of possible differences;

(c) scale factors are selected on the basis of the sequence of $(k-1)*n$ value classes formed according to step (b) - separately for each one of the n sub-bands or spectral value groups, respectively - and are provided with identifying information, with the number of successive, different, selected scale factors within the sequence being less than or equal to the number of successive, different scale factors of the considered sub-band or spectral value group; and wherein the identifying information identifies the association of each one of the selected scale factors with one or a plurality of the k blocks of the sampled signal values of the respective sub-band or spectral value group, respectively,

and wherein, in the decoder:

(d) the associated, selected scale factors are assigned with the aid of the identifying information to the blocks of the sampled signal values; and

(e) audio signals are regenerated from the sampled signal values and from the assigned selected scale factors, with these audio signals more or less corresponding to the original audio signals,

**characterized in that** during the block coding the following method steps are provided within irrelevance and redundance reducing audio data reduction methods:

(f) the $(k-1)n$ differences formed according to step (a) are grouped into more than two value classes;

(g) in the selection of scale factors according to step (c), a transmission pattern of new scale factors is determined separately for each one of the n sub-bands or spectral value groups, respectively, according to psychoacoustic aspects with respect to the pre-masking and post-masking effects of the human auditory system, with a distinction being made between psycho-acoustically relevant changes in the scale factors; and

(h) a control information indicating at which locations k the new scale factors are disposed is employed as the identifying information.

2. A method according to claim 1, **characterized in that** the control information indicates, if appropriate, that no new scale factor is being transmitted, but that the preceding new scale factor is applicable for all relevant k blocks.

**Revendications**

1. Procédé de transmission de signaux audio numérisé, codés par blocs, en utilisant des facteurs d'échelle qui sont formés pendant le codage des blocs des signaux audio numérisés à partir de l'ampleur de la valeur maximale d'une séquence (bloc) de valeurs de signaux et sont amenés sous forme quantifiée aux valeurs explorées de signaux de la séquence respective, dans lequel, dans le codeur:

(a) à partir d'une série de k facteurs d'échelle successifs dans le temps ($scf_{11}$, $scf_{12}$ à $scf_{1k}$; ... $scf_{n1}$, $Scf_{n2}$, ... $scf_{nk}$) de chaque sous-bande de fréquence ou d'un groupe de valeurs spectrales du signal audio subdivisé en n sous-bandes ou valeurs spectrales (où $n \geq 1$), les différences

$$d_{12-11} = scf_{12} - scf_{11}$$
$$\text{à}$$
$$d_{1k - 1(k - 1)} = scf_{1K} - scf_{1(k - 1)};$$
$$d_{n2 - n1} = scf_{n2} - scf_{n1}$$
$$\text{à}$$
$$d_{nk - n(k - 1)} = sfn_{nk} - scf_{n(k - 1)}$$

sont formées selon le signe et l'ampleur;

(b) les $(k-1)*n$ différences formées selon l'étape (a) sont classées en au moins deux classes de valeurs, chacune de ces classes de valeurs incluant une quantité égale à une différence ou plusieurs différences possibles;

(c) des facteurs d'échelle sont choisis, sur la base de la séquence de (k-1)∗n classes de valeurs formées selon l'étape (b), séparément pour chacune des n sous bandes ou groupes de valeurs spectrales, respectivement, et reçoivent une information d'identification, le nombre de facteurs d'échelle choisis successifs, différents, à l'intérieur de la séquence étant inférieur ou égal au nombre des facteurs d'échelle successifs, différents, de la sous-bande ou du groupe de valeurs spectrales considéré; et dans lequel l'information d'identification identifie l'assignation de chacun des facteurs d'échelle choisis à l'un des k blocs ou à plusieurs k blocs des valeurs explorées de signaux de la sous-bande ou du groupe de valeurs spectrales respectifs, respectivement,

et dans lequel, dans le codeur:

(d) les facteurs d'échelle choisis assignés sont associés à l'aide de l'information d'identification aux blocs des valeurs explorées de signaux; et

(e) des signaux audio sont régénérés à partir des valeurs explorées de signaux et à partir des facteurs d'échelle choisis assignés, ces signaux audio correspondant plus ou moins aux signaux audio d'origine,

caractérisé en ce que les étapes suivantes du procédé sont réalisées pendant le codage du bloc, à l'intérieur de procédés de réduction de données audio qui réduisent l'irrélévance et la redondance:

(f) les (k-1)n différences formées à l'étape (a) sont groupées en plus de deux classes de valeurs;

(g) dans le choix des facteurs d'échelle selon l'étape (c), un échantillon de transmission de nouveaux facteurs d'échelle est déterminée séparément pour chacune des n sous-bandes ou groupes de valeurs spectrales, respectivement, selon des aspects psycho-acoustiques par rapport aux effets de masquage préalable et de masquage postérieur du système auditif humain, une distinction étant faite entre des variations psycho-acoustiquement déterminantes dans les facteurs d'échelle; et

(h) une information de commande indiquant à quels emplacements k les nouveaux facteurs d'échelle sont disposés est employée comme une information de commande.

2. Procédé selon la revendication 1, caractérisé en ce que l'information de commande indique éventuellement qu'aucun nouveau facteur d'échelle n'est transmis, mais que le nouveau facteur d'échelle précédent est valable pour tous les blocs k concernés.